# EUROPÄISCHE PATENTSCHRIFT

(11) **EP 1 158 527 B1**
(45) Veröffentlichungstag und Bekanntmachung des Hinweises auf die Patenterteilung: **13.02.2008**
(21) Anmeldenummer: 01111879.1
(22) Anmeldetag: 16.05.2001
(51) Int. Cl.: G11C 8/00, G11C 8/08

(54) **Integrierter Speicher mit Zeilenzugriffssteuerung zur Aktivierung und Vorladung von Zeilenleitungen und Verfahren zum Betrieb eines solchen Speichers**
Integrated memory with word line access control for activating and precharging word lines and driving method of such memory
Mémoire intégrée avec commande d'accès de lignes de mot pour activer et précharger des lignes de mot et méthode d'opération d'une telle mémoire

(30) Priorität: 24.05.2000 DE 10025569
(43) Veröffentlichungstag der Anmeldung: 28.11.2001
(73) Patentinhaber: Infineon Technologies AG, 81669 München (DE)
(72) Erfinder: Dietrich, Stefan, Dr., 82299 Türkenfeld (DE); Schöniger, Sabine, 83734 Hausham (DE); Schrögmeier, Peter, 81547 München (DE); Weis, Christian, 81737 München (DE)
(74) Vertreter: Epping - Hermann - Fischer

(56) Entgegenhaltungen:
- US-A- 4 281 399
- US-A- 4 338 679
- US-A- 4 638 462
- US-A- 5 555 526

## Beschreibung

Die vorliegende Erfindung betrifft einen integrierten Speicher mit den Merkmalen des Oberbegriffs des Anspruchs 1 sowie ein Verfahren zum Betrieb eines solchen Speichers.

Ein solcher Speicher ist zum Beispiel aus US-A-5,555,526 bekannt. Bei diesem Speicher wird eine Zeilenleitung dann vorgeladen ("precharged"), wenn das Auslesen oder Schreiben eines Datensignals als beendet zu betrachten ist, wobei dieser Zeitpunkt ermittelt wird durch Auswerten der für den Speicher bekannten und in Taktzyklen gemessenen Werte für die Burst Length and CAS Latency.

Ein integrierter Speicher weist im allgemeinen ein Speicherzellenfeld auf, das Spaltenleitungen und Zeilenleitungen umfaßt. Die Speicherzellen sind dabei in Kreuzungspunkten der Spaltenleitungen und Zeilenleitungen angeordnet. Zur Auswahl einer der Speicherzellen sind diese jeweils mit einer der Zeilenleitungen verbunden. Dazu wird beispielsweise ein Auswahltransistor von jeweiligen Speicherzellen durch eine aktivierte Zeilenleitung leitend geschaltet, wodurch im Anschluß ein Auslesen oder Schreiben eines Datensignals einer entsprechenden ausgewählten Speicherzelle erfolgen kann. Die ausgewählte Speicherzelle ist dazu mit einer der Spaltenleitungen verbunden, über die das entsprechende Datensignal ausgelesen beziehungsweise eingeschrieben wird.

In einem inaktiven Zustand sind die Zeilenleitungen üblicherweise auf ein Vorladepotential vorgeladen. Daß heißt, nach dem Lesen oder Schreiben eines Datensignals wird die entsprechende aktivierte Zeilenleitung durch einen Vorladevorgang wieder auf das Vorladepotential vorgeladen. Die Steuerung dieses Vorladevorgangs sowie die Aktivierung einer der Zeilenleitungen für die Auswahl einer der Speicherzellen erfolgt im allgemeinen durch eine Zeilenzugriffssteuerung.

Insbesondere bei synchronen Speichern wie sogenannten SDRAM oder SGRAM wird infolge steigender Anforderungen durch Erhöhung der Betriebsfrequenz (Taktrate) die Datenverarbeitungsgeschwindigkeit fortschreitend erhöht. Dadurch wird die Zugriffszeit für einen einzelnen Speicherzellenzugriff zunehmend verkürzt. Dabei ist nach wie vor sicherzustellen, daß eine festgelegte minimale Zeitspanne, in der eine Zeilenleitung zum Lesen oder Schreiben eines Datensignals zu aktivieren ist, eingehalten wird. Diese minimale Zeitspanne ist meist physikalisch bedingt, beispielsweise durch die Länge der Zeilenleitung und die damit verbundene kapazitive Last.

Ein Vorladevorgang wird üblicherweise durch Anlegen eines sogenannten Vorladebefehls eingeleitet, der beispielsweise vor oder während eines Zeilenzugriffs angelegt wird. Dabei ist es grundsätzlich möglich, daß dieser Vorladebefehl zu einem verfrühten Vorladen führt, d.h. die betreffende Zeilenleitung wird vorgeladen bevor die minimale Zeitspanne verstrichen ist. Wird diese minimale Aktivierungszeitspanne einer der Zeilenleitungen verletzt, so kann dies zu einem Datenverlust beim Lesen oder Schreiben eines Datensignals führen.

Die Aufgabe der vorliegenden Erfindung ist es, einen integrierten Speicher der eingangs genannten Art anzugeben, bei dem sichergestellt ist, daß eine minimale Aktivierungszeitspanne einer Zeilenleitung beim Auslesen oder Schreiben eines Datensignals eingehalten wird, unabhängig davon, wann eine Zeilenleitung aktiviert wird und/oder wie lange ein Auslesevorgang oder Schreibvorgang andauert.

Weiterhin ist es Aufgabe der vorliegenden Erfindung, ein Verfahren zum Betrieb eines integrierten Speichers der eingangs genannten Art anzugeben, durch das sichergestellt ist, daß die minimale Aktivierungszeitspanne einer Zeilenleitung beim Auslesen oder Schreiben eines Datensignals eingehalten wird.

Die Aufgabe betreffend den integrierten Speicher wird gelöst wie im Anspruch 1 angegeben.

Die Aufgabe betreffend das Verfahren wird gelöst wie im Anspruch 8 angegeben.

Durch die Erfindung ist sichergestellt, daß eine minimale Aktivierungszeitspanne einer zu aktivierenden Zeilenleitung beim Auslesen oder Schreiben eines Datensignals eingehalten wird. Der Vorladevorgang für die aktivierte Zeilenleitung wird nämlich erst dann ausgelöst, wenn nach einem vollständigen Speicherzellenzugriff die minimale Aktivierungszeitspanne verstrichen ist. Das bedeutet, daß nach dem Lesen oder Schreiben so lange mit dem Vorladen der Zeilenleitung gewartet wird, bis die Aktivierungszeitspanne verstrichen ist, unabhängig davon, wie lange der Auslesevorgang oder Schreibvorgang andauert. Ferner wird mit dem Vorladen so lange gewartet, bis das Auslesen oder Schreiben des Datensignals beendet ist, unabhängig davon, wann die entsprechende Zeilenleitung aktiviert wird. Ein Vorladevorgang einer aktivierten Zeilenleitung wird vorteilhaft in selbstjustierende Weise vorgenommen.

Die Erfindung ist vorteilhaft bei einem synchronen Speicher anwendbar, der einen Anschluß für ein Taktsignal aufweist, das als Betriebsfrequenz des synchronen Speichers dient. Durch die selbstjustierende Steuerung des Vorladevorgangs nach dem Ende eines Auslese- oder Schreibvorgangs wird vermieden, daß beispielsweise ein Sicherheitsabstand von z.B. zwei Taktperioden eingeführt werden muß, so daß die minimale Aktivierungszeitspanne nicht verletzt wird. Dadurch wäre bei wachsender Betriebsfrequenz und Komplexität der Anforderungen an den integrierten Speicher die Bandbreite der zu verarbeitenden Daten stark eingeschränkt. Durch die Erfindung ist es möglich, mit dem Vorladen so lange zu warten, bis die analoge Aktivierungszeitspanne verstrichen ist, so daß unmittelbar in der darauffolgenden Taktperiode ein Vorladevorgang ausgelöst werden kann.

In einer Ausführungsform des erfindungsgemäßen Verfahrens werden mehrere Vorladebefehle zur Vorladung jeweiliger Zeilenleitungen nacheinander angelegt. Dabei ist es möglich, daß bei unterschiedlichen Aktivierungszeitpunkten der jeweiligen zu aktivierenden Zeilenleitungen eine unterschiedliche Reihenfolge von Vorladevorgängen der jeweiligen Zeilenleitungen auftreten kann. Daher erfolgt eine Speicherung von Adressen der vorzuladenden Zeilenleitungen, wobei anhand der gespeicherten Adressen eine Reihenfolge festgelegt wird, in der die jeweiligen Zeilenleitungen vorzuladen sind.

In einer Ausführungsform des integrierten Speichers ist die Steuereinheit dabei mit einem Anschluß für ein Adreßsignal zur Adressierung einer der Zeilenleitungen verbunden. Die Steuereinheit enthält eine Speicherschaltung zur Speicherung von Adreßsignalen auszuwählender Zeilenleitungen.

In einer Weiterbildung des erfindungsgemäßen Speichers weist die Speicherschaltung ein Schieberegister auf, durch das ein serielles Einlesen der Adreßsignale mehrerer auszuwählender Zeilenleitungen infolge eines jeweiligen Vorladebefehls erfolgt. Eine Ausgabe der Adreßsignale wird dabei in der gleichen Reihenfolge wie beim Einlesen der Adreßsignale durchgeführt. Damit durch die Zeilenzugriffssteuerung die entsprechende Zeilenleitung vorgeladen werden kann, löst das Ausgangssignal entsprechend der durch das Schieberegister ausgegebenen Adreßsignale einen Vorladevorgang einer entsprechenden Zeilenleitung aus. Es wird also anhand des Adreßsignals durch die Zeilenzugriffssteuerung ein Vorladevorgang der entsprechenden Zeilenleitung ausgelöst.

Die Aktivierungszeitspanne, in der eine aktivierte Zeilenleitung aktiviert ist, wird beispielsweise durch die Zeilenzugriffssteuerung festgestellt. Dadurch ist in einer Ausführungsform des erfindungsgemäßen Speichers der dritte Eingang der Steuereinheit mit der Zeilenzugriffssteuerung verbunden. Der Steuereinheit wird also aus der Zeilenzugriffssteuerung eine Information zugeführt, anhand welcher ein Vorlade-Zeitpunkt einer auswählten Zeilenleitung nach einem Auslese- oder Schreibvorgang determiniert wird.

In einer weiteren Ausführungsform des erfindungsgemäßen Speichers weist dieser eine zentrale Steuerungseinrichtung auf zur Steuerung eines Speicherzellenzugriffs. Die zentrale Steuerungseinrichtung ist mit dem ersten und zweiten Eingang der Steuereinheit verbunden. Das bedeutet, der decodierte Vorladebefehl und das Signal, das anzeigt, daß ein Auslesen oder Schreiben eines Datensignals beendet ist, wird von der zentralen Steuerungseinrichtung der Steuereinheit zugeführt. Die zentrale Steuerungseinrichtung steuert beispielsweise zusätzlich das Auslesen beziehungsweise das Schreiben eines Datensignals der ausgewählten Speicherzelle.

In einer weiteren Ausführungsform der Erfindung sind die Speicherzellen zu Zeileneinheiten zusammengefaßt, die jeweils mehrere Zeilenleitungen enthalten. Dementsprechend wird jeweils eine der Zeileneinheiten für die Auswahl einer der Speicherzellen aktiviert und entsprechend ein Vorladevorgang jeweils für eine der Zeileneinheiten durchgeführt. Dazu wird entsprechend ein Vorladebefehl für eine zu aktivierende Zeileneinheit von Speicherzellen an einen Anschluß des Speichers, beispielsweise den ersten Eingang der Steuereinheit, angelegt. Der Vorladevorgang für die aktivierte Zeileneinheit wird ausgelöst, wenn das Auslesen oder Schreiben des Datensignals beendet ist und wenn die minimale Zeitspanne, in der die Zeileneinheit mindestens zu aktivierten ist, seit der Aktivierung verstrichen ist. Die Zeileneinheiten der Speicherzellen sind beispielsweise Speicherbereiche, die als sogenannte Speicherbänke bezeichnet werden.

Die Erfindung ist auf mehrere Arten von integrierten Speichern anwendbar, die jeweils Zeilenleitungen zur Auswahl von Speicherzellen für das Auslesen oder Schreiben von Datensignalen aufweisen.

Die Erfindung wird im folgenden anhand der in der Zeichnung dargestellten Figuren, die Ausführungsbeispiele darstellen, näher erläutert. Es zeigen:
- Figur 1: eine Ausführungsform des erfindungsgemäßen integrierten Speichers,
- Figur 2: eine detailliertere Darstellung einer Ausführungsform des integrierten Speichers,
- Figur 3: ein Flußdiagramm zur Durchführung des erfindungsgemäßen Verfahrens.

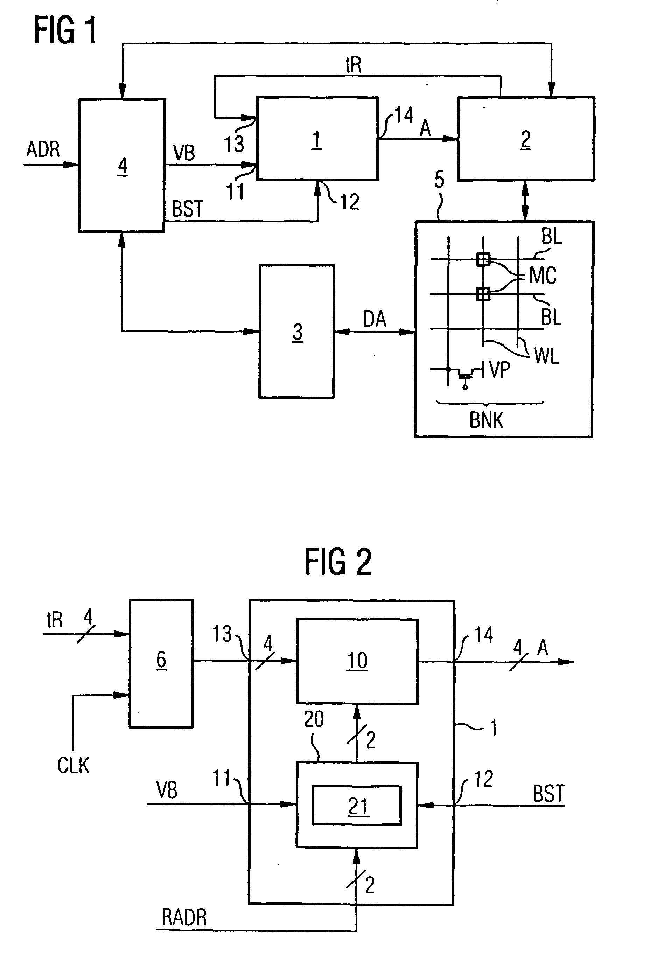

Figur 1 ist eine Ausführungsform des integrierten Speichers zu entnehmen, der ein Speicherzellenfeld 5 aufweist, das Spaltenleitungen BL und Zeilenleitungen WL aufweist. Die Speicherzellen MC sind dabei in Kreuzungspunkten der Spaltenleitungen BL und Zeilenleitungen WL angeordnet. Die Speicherzellen MC sind weiterhin jeweils mit einer der Zeilenleitungen WL zur Auswahl einer der Speicherzellen MC verbunden. Weisen die Speicherzellen beispielsweise einen Speicherkondensator und einen Auswahltransistor auf, so sind die Zeilenleitungen WL jeweils mit Steueranschlüssen der entsprechenden Auswahltransistoren der Speicherzellen MC verbunden. Zum Auslesen oder Schreiben eines Datensignals DA ist eine entsprechende Speicherzelle MC mit einer der Spaltenleitungen BL verbunden. Das Auslesen beziehungsweise Schreiben des Datensignals DA wird beispielsweise über eine Spaltenzugriffssteuerung 3 gesteuert.

Der Speicher weist außerdem eine Zeilenzugriffssteuerung 2 auf zur Aktivierung einer der Zeilenleitungen WL für die Auswahl einer der Speicherzellen MC. Die Zeilenzugriffssteuerung 2 dient außerdem zur Steuerung eines Vorladevorgangs zur Vorladung einer der Zeilenleitungen WL. Die Zeilenleitungen WL können in einer Ausführungsform zu Zeileneinheiten oder Speicherbänken BNK zusammengefaßt werden

Zur Durchführung eines Speicherzellenzugriffs wird die Adresse ADR einer auszuwählenden Speicherzelle an eine zentrale Steuerungseinrichtung 4 angelegt. Diese dient zur Steuerung des Speicherzellenzugriffs. Es erfolgt eine Aktivierung der adressierten Zeilenleitung durch die Zeilenzugriffssteuerung 2. Durch Adressierung der entsprechenden Spaltenleitung wird die auszuwählende Speicherzelle ausgewählt, und es wird deren Datensignal DA über die Spaltenzugriffssteuerung 3 ausgelesen beziehungsweise eingeschrieben. Zur Steuerung eines derartigen Speicherzellenzugriffs sind die Zeilenzugriffssteuerung 2 und die Spaltenzugriffssteuerung 3 mit der zentralen Steuerungseinrichtung 4 verbunden.

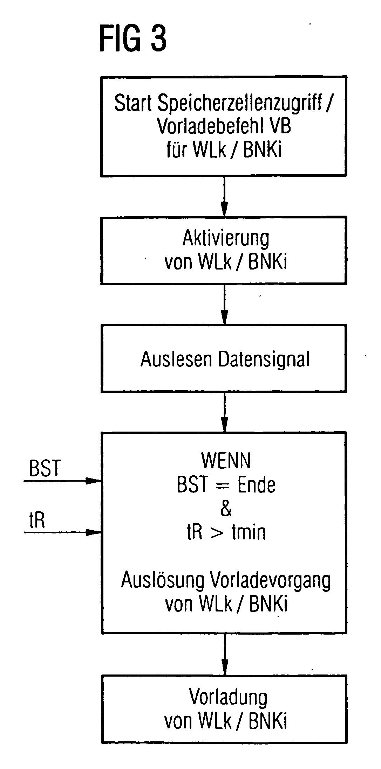

Figur 3 zeigt ein Flußdiagramm zur Durchführung eines beispielhaften Betriebsverfahrens. Zu Beginn eines Speicherzellenzugriffs wird ein sogenannter Burst-Befehl beispielsweise an die zentrale Steuerungseinrichtung 4 angelegt, der einen Speicherzellenzugriff auslöst und zusätzlich einen Vorladebefehl VB (sogenanntes "Autoprecharge") für die betreffende Zeilenleitung WLk beziehungsweise die betreffende Zeileneinheit BNKi (Speicherbank) beinhaltet. Durch das Anlegen des Vorladebefehls VB wird ein Auslösen des Vorladevorgangs eingeleitet. In einem weiteren Schritt wird die zu aktivierende Zeilenleitung WLk beziehungsweise Zeileneinheit BNKi für die Auswahl einer der Speicherzellen MC durch die Zeilenzugriffssteuerung 2 aktiviert. Im Anschluß daran wird das auszulesende Datensignal DA der ausgewählten Speicherzelle aus der Speicherzelle ausgelesen.

Damit ein Vorladevorgang der aktivierten Zeilenleitung WLk beziehungsweise der Zeileneinheit BNKi ausgelöst werden kann, müssen zwei Bedingungen eintreten. Zum einen muß das Auslesen des Datensignals beendet sein. Dies wird durch das Signal BST angezeigt, das beispielsweise von der zentralen Steuerungseinrichtung 4 gemäß Figur 1 erzeugt wird. Des weiteren muß eine festgelegte Zeitspanne tmin verstrichen sein, in der die aktivierte Zeilenleitung WLk beziehungsweise Zeileneinheit BNKi mindestens zu aktivieren ist (minimale Aktivierungszeitspanne einer Zeilenleitung beziehungsweise Zeileneinheit). Diese ist beispielsweise abhängig von der jeweiligen Länge der Zeilenleitungen beziehungsweise deren jeweiligen kapazitiven Lasten. Die Information über die Aktivierungszeitspanne der aktivierten Zeilenleitung WLk wird durch das Signal tR übertragen. Sobald das Signal tR anzeigt, daß die Zeitspanne, in der die aktivierte Zeilenleitung WLk beziehungsweise Zeileneinheit BNKi aktiviert ist, größer ist als die minimale Aktivierungszeitspanne tmin, wird ein entsprechender Vorladevorgang der aktivierten Zeilenleitung WLk beziehungsweise Zeileneinheit BNKi ausgelöst. Die aktivierte Zeilenleitung WLk beziehungsweise Zeileneinheit BNKi wird nach dem Auslösen des Vorladevorgangs auf das Vorladepotential VP vorgeladen.

Zur Steuerung eines derartigen Betriebsverfahrens weist der integrierte Speicher gemäß Figur 1 eine Steuereinheit 1 auf. Diese weist einen ersten Eingang 11 auf, der mit dem Signalanschluß für den decodierten Vorladebefehl VB verbunden ist. In dieser Ausführungsform wird der Vorladebefehl VB von der zentralen Steuerungseinrichtung 4 erzeugt. Diese ist daher mit dem ersten Eingang 11 der Steuereinheit 1 verbunden. Ein zweiter Eingang 12 der Steuereinheit 1 ist mit dem Signalanschluß für das Signal BST verbunden. Dieses wird in dieser Ausführungsform ebenfalls von der zentralen Steuerungseinrichtung 4 erzeugt, die dazu mit dem zweiten Eingang 12 der Steuereinheit 1 verbunden ist. Die Steuereinheit 1 weist weiterhin einen dritten Eingang 13 auf, der mit dem Signalanschluß für das Sigal tR verbunden ist. Im dargestellten Ausführungsbeispiel wird das Signal tR, das Information über die Zeitspanne enthält, in der die aktivierte Zeilenleitung WLk aktiviert ist, durch die Zeilenzugriffssteuerung 2 erzeugt. Die Zeilenzugriffssteuerung 2 ist daher mit dem dritten Eingang 13 der Steuereinheit 1 verbunden. Die Steuereinheit weist weiterhin einen Ausgang 14 auf, der mit der Zeilenzugriffssteuerung 2 verbunden ist. Der Ausgang 14 dient zur Ausgabe des Ausgangssignals A, das einen Vorladevorgang einer der aktivierten Zeilenleitung WLk durch die Zeilenzugriffssteuerung 2 auslöst.

Figur 2 zeigt eine detailliertere Ausführungsform des erfindungsgemäßen integrierten Speichers. Die Steuereinheit 1 enthält eine Speicherschaltung 20 zur Speicherung von Adreßsignalen RADR auszuwählender Zeilenleitungen WL beziehungsweise von Zeileneinheiten BNK. Die Steuereinheit 1 ist dazu mit einem Anschluß für das Adreßsignal RADR zur Adressierung verbunden.

In einem Betriebsverfahren werden beispielsweise mehrere Vorladebefehle VB zur Vorladung jeweiliger Zeilenleitungen WLk beziehungsweise Zeileneinheiten BNKi nacheinander angelegt. Es erfolgt dann eine Speicherung der Adressen RADR der vorzuladenden Zeilenleitungen beziehungsweise Zeileneinheiten in der Speicherschaltung 20. Es kann dann anhand der gespeicherten Adressen RADR eine Reihenfolge festgelegt werden, in der die jeweiligen Zeilenleitungen WLk beziehungsweise Zeileneinheiten BNKi vorzuladen sind.

In diesem Beispiel sei vereinfachend angenommen, daß der Speicher vier Zeileneinheiten beziehungsweise Speicherbänke BNK aufweist. Es ist daher ein 2-Bit Adreßsignal RADR zu übertragen. Das Signal RADR enthält eine Information, welche der vier Speicherbänke für einen Speicherzellenzugriff verwendet wird.

Die Speicherschaltung 20 enthält in diesem Beispiel ein Schieberegister 21, durch das ein serielles Einlesen der Adreßsignale RADR mehrerer auszuwählender Zeilenleitungen WLk beziehungsweise Zeileneinheiten BNKi infolge eines jeweiligen Vorladebefehls VB erfolgt. Der decodierte Vorladebefehl VB dient dabei als Eintaktungssignal für das Schieberegister 21.

Bei dem Schieberegister 21 handelt es sich beispielsweise um einen sogenannten FIFO (First In First Out) Speicher. Bei jedem Vorladebefehl VB wird das dazu gehörige Adreßsignal RADR in das Schieberegister 21 getaktet. Als Austaktungssignal wird das Signal BST verwendet, das das Ende des jeweiligen Auslese- beziehungsweise Schreibvorgangs anzeigt. Bei jedem Austaktungssignal BST wird diejenige Speicherbank BNKi an die Steuerung 10 übermittelt, die gerade einen Auslese- beziehungsweise Schreibvorgang beendet hat. Das heißt, daß eine Ausgabe der in dem Schieberegister 21 gespeicherten Adreßsignale RADR in der gleichen Reihenfolge erfolgt, wie das Einlesen. Es wird dabei davon ausgegangen, daß die Zeitdauern der einzelnen Auslese- beziehungsweise Schreibvorgänge (sogenannte Burst-Länge) für jeden Speicherzellenzugriff gleich lang sind.

Da der Speicher in diesem Beispiel vier Speicherbänke BNK aufweist, liegt auch ein vierphasiges Signal tR vor. Dem dritten Eingang 13 der Steuereinheit 1 ist dabei eine Synchronisationsschaltung 6 vorbeschaltet zur zeitlichen Synchronisation des Signals tR mit dem Taktsignal clk des integrierten Speichers, der hier als synchroner Speicher ausgeführt ist. Das heißt, die vier Teilsignale des Signals tR werden zur weiteren Verwendung mit dem Taktsignal clk synchronisiert. Mit dem synchronisierten Signal tR und den von der Speicherschaltung 20 ausgegebenen Adreßsignalen RADR wird in der Steuerung 10 das Ausgangssignal A zum Auslösen eines Vorladevorgangs einer der vier Speicherbänke BNKi erzeugt. Da für jede der vier Speicherbänke BNKi eine eigene Zeilenzugriffssteuerung vorhanden ist, existiert demnach ein vierphasiges Ausgangssignal A zum Auslösen eines jeweiligen Vorladevorgangs. Ein Teilsignal des Ausgangssignals A löst schließlich einen Vorladevorgang für eine entsprechende Speicherbank BNKi aus.

## Patentansprüche

1. Integrierter Speicher
- mit einem Speicherzellenfeld (5), das Spaltenleitungen (BL) und Zeilenleitungen (WL) aufweist,
- mit Speicherzellen (MC), die jeweils mit einer der Zeilenleitungen (WL) zur Auswahl einer der Speicherzellen (MC) und mit einer der Spaltenleitungen (BL) zum Auslesen oder Schreiben eines Datensignals (DA) verbunden sind,
- mit einer Zeilenzugriffssteuerung (2) zur Aktivierung einer der Zeilenleitungen (WL) für die Auswahl einer der Speicherzellen (MC) und zur Steuerung eines Vorladevorgangs zur Vorladung einer der Zeilenleitungen (WL),
mit einer Steuereinheit (1) mit
- einem ersten Eingang (11), der mit einem Signalanschluß für einen decodierten Vorladebefehl (VB) verbunden ist, der ein Auslösen des Vorladevorgangs einer der Zeilenleitungen (WL) einleitet,
- einem zweiten Eingang (12), der mit einem Signalanschluß für ein Signal (BST) verbunden ist, das anzeigt, daß das Auslesen oder Schreiben eines Datensignals (DA) beendet ist, und
- einem Ausgang (14), der mit der Zeilenzugriffssteuerung (2) verbunden ist, zur Ausgabe eines Ausgangssignals (A) zum Auslösen des Vorladevorgangs einer der Zeilenleitungen (WL),
**dadurch gekennzeichnet, dass** die Steuereinheit einen dritten Eingang (13) aufweist, der mit einem Signalanschluß für ein Signal (tR) verbunden ist, das Information über eine Zeitspanne enthält, in der eine aktivierte Zeilenleitung (WLk) aktiviert ist.

2. Integrierter Speicher nach Anspruch 1,
**dadurch gekennzeichnet, daß**
der integrierte Speicher eine zentrale Steuerungseinrichtung (4) zur Steuerung eines Speicherzellenzugriffs umfaßt, die mit dem ersten Eingang (11) und zweiten Eingang (12) der Steuereinheit (1) verbunden ist.

3. Integrierter Speicher nach Anspruch 1 oder 2,
**dadurch gekennzeichnet, daß**
die Zeilenzugriffssteuerung (2) mit dem dritten Eingang (13) der Steuereinheit (1) verbunden ist.

4. Integrierter Speicher nach einem der Ansprüche 1 bis 3,
**dadurch gekennzeichnet, daß**
die Steuereinheit (1) mit einem Anschluß für ein Adreßsignal (RADR) zur Adressierung einer der Zeilenleitungen (WL) verbunden ist und eine Speicherschaltung (20) enthält zur Speicherung von Adreßsignalen (RADR) auszuwählender Zeilenleitungen (WLk).

5. Integrierter Speicher nach Anspruch 4,
**dadurch gekennzeichnet, daß**
- die Speicherschaltung (20) ein Schieberegister (21) enthält, durch das ein serielles Einlesen der Adreßsignale (RADR) mehrerer auszuwählender Zeilenleitungen (WLk) infolge eines jeweiligen Vorladebefehls (VB) erfolgt, und durch das eine Ausgabe der Adreßsignale (RADR) in der gleichen Reihenfolge erfolgt,
- das Ausgangssignal (A) der Steuereinheit (1) entsprechend der durch das Schieberegister (21) ausgegebenen Adreßsignale (RADR) einen Vorladevorgang einer der Zeilenleitungen (WL) auslöst.

6. Integrierter Speicher nach einem der Ansprüche 1 bis 5,
**dadurch gekennzeichnet, daß**
der integrierte Speicher als synchroner Speicher mit einem Anschluß für ein Taktsignal (clk) ausgeführt ist.

7. Integrierter Speicher nach Anspruch 6,
**dadurch gekennzeichnet, daß**
dem dritten Eingang (13) der Steuereinheit (1) eine Synchronisationschaltung (6) vorgeschaltet ist zur zeitlichen Synchronisation des am dritten Eingang (13) anliegenden Signals (tR) mit dem Taktsignal (clk).

8. Verfahren zum Betrieb eines integrierten Speichers gemäß Anspruch 1, wobei das Verfahren folgendes umfasst:
- es wird an einen Anschluß (11) des Speichers ein Vorladebefehl (VB) für eine zu aktivierende Zeilenleitung (WLk) angelegt, der ein Auslösen des Vorladevorgangs einleitet,
- die zu aktivierende Zeilenleitung (WLk) wird für die Auswahl einer der Speicherzellen (MC) durch die Zeilenzugriffssteuerung (2) aktiviert,
- es wird ein Datensignal (DA) einer ausgewählten Speicherzelle aus der Speicherzelle ausgelesen oder in die Speicherzelle geschrieben,
- die aktivierte Zeilenleitung (WLk) wird nach dem Auslösen des Vorladevorgangs vorgeladen,
wobei
der Vorladevorgang für die aktivierte Zeilenleitung (WLk) durch die Zeilenzugriffssteuerung (2) erst ausgelöst wird, wenn das Auslesen oder Schreiben des Datensignals (DA) beendet ist und wenn eine festgelegte Zeitspanne (tmin), in der die Zeilenleitung (WLk) mindestens zu aktivieren ist, seit der Aktivierung verstrichen ist.

9. Verfahren nach Anspruch 8,
**dadurch gekennzeichnet, daß**
- mehrere Vorladebefehle (VB) zur Vorladung jeweiliger Zeilenleitungen (WLk) nacheinander angelegt werden,
- eine Speicherung von Adressen (RADR) der jeweiligen vorzuladenen Zeilenleitungen (WLk) erfolgt,
- anhand der gespeicherten Adressen (RADR) eine Reihenfolge festgelegt wird, in der die jeweiligen Zeilenleitungen (WLk) vorzuladen sind.

10. Verfahren nach Anspruch 8 oder 9,
**dadurch gekennzeichnet, daß**
- die Speicherzellen (MC) zu Zeileneinheiten (BNK) zusammengefaßt sind, die jeweils mehrere Zeilenleitungen (WL) enthalten,
- ein Vorladebefehl (VB) für eine zu aktivierende Zeileneinheit (BNKi) von Speicherzellen angelegt wird,
- die zu aktivierende Zeileneinheit (BNKi) für die Auswahl einer der Speicherzellen (MC) aktiviert wird,
- der Vorladevorgang für die aktivierte Zeileneinheit (BNKi) ausgelöst wird, wenn das Auslesen oder Schreiben des Datensignals (DA) beendet ist und wenn eine Zeitspanne (tmin), in der die Zeileneinheit (BNKi) mindestens zu aktivieren ist, seit der Aktivierung verstrichen ist,
- die aktivierte Zeileneinheit (BNKi) nach dem Auslösen des Vorladevorgangs vorgeladen wird.

## Claims

1. Integrated memory
- having a memory cell array (5) which has column lines (BL) and row lines (WL),
- having memory cells (MC) which are each connected to one of the row lines (WL) to select one of the memory cells (MC) and to one of the column lines (BL) to read or write a data signal (DA),
- having a row access controller (2) to activate one of the row lines (WL) to select one of the memory cells (MC) and to control a precharging operation to precharge one of the row lines (WL),
having a control unit (1) having
- a first input (11), which is connected to a signal terminal for a decoded precharge command (VB), which initiates the triggering of the precharging operation of one of the row lines (WL),
- a second input (12), which is connected to a signal terminal for a signal (BST) which indicates that the reading or writing of a data signal (DA) has been finished, and
- an output (14), which is connected to the row access controller (2) for outputting an output signal (A) to trigger the precharging operation of one of the row lines (WL),
**characterized in that** the control unit has a third input (13), which is connected to a signal terminal for a signal (tR) which contains information about a time interval during which an activated row line (WLk) is activated.

2. Integrated memory according to Claim 1, **characterized in that** the integrated memory comprises a central control device (4) to control a memory cell access, said control device (4) being connected to the first input (11) and second input (12) of the control unit (1).

3. Integrated memory according to Claim 1 or 2, **characterized in that** the row access controller (2) is connected to the third input (13) of the control unit (1).

4. Integrated memory according to one of Claims 1 to 3, **characterized in that** the control unit (1) is connected to a terminal for an address signal (RADR) for addressing one of the row lines (WL), and contains a storage circuit (20) to store address signals (RADR) of row lines (WLk) to be selected.

5. Integrated memory according to Claim 4, **characterized in that**
- the storage circuit (20) contains a shift register (21), by means of which the address signals (RADR) of a plurality of row lines (WLk) to be selected are read serially as a result of a respective precharge command (VB), and by means of which the address signals (RADR) are output in the same sequence,
- the output signal (A) of the control unit (1) triggers a precharging operation of one of the row lines (WL) in accordance with the address signals (RADR) output by the shift register (21).

6. Integrated memory according to one of Claims 1 to 5, **characterized in that** the integrated memory is designed as a synchronous memory having a terminal for a clock signal (clk).

7. Integrated memory according to Claim 6, **characterized in that** upstream of the third input (13) of the control unit (1) there is connected a synchronization circuit (6) for the time synchronization of the signal (tR) applied to the third input (13) with the clock signal (clk).

8. Method of operating an integrated memory according to Claim 1, the method comprising the following:
- a precharge command (VB) for a row line (WLk) to be activated is applied to a terminal (11) of the memory, said command initiating the triggering of the precharging operation,
- the row line (WLk) to be activated is activated by the row access controller (2) to select one of the memory cells (MC),
- a data signal (DA) of a selected memory cell is read from the memory cell or written to the memory cell,
- the activated row line (WLk) is precharged after the precharging operation has been triggered,
wherein the precharging operation for the activated row line (WLk) is triggered by the row access controller (2) only when the reading or writing of the data signal (DA) has been finished and when a defined time interval (tmin), during which the row line (WLk) must at least be activated, has elapsed since the activation.

9. Method according to Claim 8, **characterized in that**
- a plurality of precharge commands (VB) for precharging respective row lines (WLk) are applied one after another,
- addresses (RADR) of the respective row lines (WLk) to be precharged are stored,
- the stored addresses (RADR) are used to define a sequence in which the respective row lines (WLk) are to be precharged.

10. Method according to Claim 8 or 9, **characterized in that**
- the memory cells (MC) are combined into row units (BNK), which each contain a plurality of row lines (WL),
- a precharge command (VB) for a row unit (BNKi) of memory cells to be activated is applied,
- the row unit (BNKi) to be activated is activated to select one of the memory cells (MC),
- the precharging operation for the activated row unit (BNKi) is triggered when the reading or writing of the data signal (DA) has been finished and when a time interval (tmin), during which the row unit (BNKi) must at least be activated, has elapsed since the activation,
- the activated row unit (BNKi) is precharged after the precharging operation has been triggered.

## Revendications

1. Mémoire intégrée
- comprenant un champ (5) de cellules de mémoire, qui a des conducteurs (BL) de colonne et des conducteurs (WL) de ligne,
- comprenant des cellules (MC) de mémoire, qui sont reliées respectivement à l'un des conducteurs (WL) de ligne pour la sélection de l'une des cellules (MC) de mémoire et à l'un des conducteurs (BL) de colonne pour la lecture ou l'écriture d'un signal (DA) de données,
- comprenant une commande (2) d'accès aux ligne pour l'activation de l'un des conducteurs (BL) de lignes pour la sélection de l'une des cellules (MC) de mémoire et pour la commande d'une opération de précharge pour précharger l'un des conducteurs (WL) de ligne,
comprenant une unité (1) de commande, ayant
- une première entrée (11) qui est reliée à une borne de signal pour une instruction (VB) décodée de précharge, qui fait débuter un déclenchement de l'opération de précharge de l'un des conducteurs (WL) de ligne,
- une deuxième entrée (12) qui est reliée à une borne de signal pour un signal (BST) qui indique que la lecture ou l'écriture d'un signal (DA) de données est terminée,
- une sortie (14) qui est reliée à la commande (2) d'accès aux lignes pour émettre un signal (A) de sortie afin de déclencher l'opération de précharge de l'un des conducteurs (WL) de ligne,
**caractérisée en ce que** l'unité de commande comporte une troisième entrée (13) qui est reliée à une borne de signal pour un signal (tR) qui contient de l'information sur un laps de temps pendant lequel un conducteur (WLK) de ligne activé est activé.

2. Mémoire intégrée suivant la revendication 1, **caractérisée en ce que**
la mémoire intégrée comprend un dispositif (4) central de commande pour la commande d'un accès aux cellules de mémoire, qui est relié à la première entrée (11) et à la deuxième entrée (12) de l'unité (1) de commande.

3. Mémoire intégrée suivant la revendication 1 ou 2, **caractérisée en ce que** la commande (2) d'accès aux lignes est reliée à la troisième entrée (13) de l'unité (1) de commande.

4. Mémoire intégrée suivant l'une des revendications 1 à 3, **caractérisée en ce que** l'unité (1) de commande est reliée à une borne pour un signal (RADR) d'adresse pour l'adressage de l'un des conducteurs (WL) de ligne et comporte un circuit (20) de mémoire pour la mémorisation de signaux (RADR) d'adresse de conducteurs (WLK) de ligne à sélectionner.

5. Mémoire intégrée suivant la revendication 4, **caractérisée en ce que**
- le circuit (20) de mémoire comporte un registre (21) à décalage, par lequel une lecture séquentielle des signaux (RADR) d'adresses de plusieurs conducteurs (WLK) de ligne à sélectionner s'effectue en fonction d'une instruction (VB) de précharge respective et par lequel une émission des signaux (RADR) d'adresses s'effectue dans le même ordre,
- le signal (A) de sortie de l'unité (1) de commande déclenche une opération de précharge de l'un des conducteurs (WL) de ligne en correspondance avec les signaux (RADR) d'adresse émis par le registre (21) à décalage.

6. Mémoire intégrée suivant l'une des revendications 1 à 5, **caractérisée en ce que** la mémoire intégrée est réalisée en mémoire synchrone ayant une borne pour une signal (CLK) d'horloge.

7. Mémoire intégrée suivant la revendication 6, **caractérisée en ce qu'**il est monté, en amont de la troisième entrée (13) de l'unité (1) de commande, un circuit (6) de synchronisation pour la synchronisation dans le temps du signal (tR) s'appliquant à la troisième entrée (13) avec le signal (CLK) d'horloge.

8. Procédé pour faire fonctionner une mémoire intégrée suivant la revendication 1, le procédé comprenant ce qui suit :
- on applique à une borne (11) de la mémoire une instruction (VB) de précharge pour un conducteur (WLK) de ligne à activer, instruction qui fait débuter un déclenchement de l'opération de précharge,
- on active le conducteur (WLK) de ligne à activer pour la sélection de l'une des cellules (MC) de mémoire par la commande (2) d'accès aux lignes,
- on lit ou on écrit dans la cellule de mémoire un signal (DA) de données d'une cellule de mémoire à sélectionner,
- on précharge le conducteur (WLK) de ligne à activer après le déclenchement de l'opération de précharge,
dans lequel
on ne déclenche l'opération de précharge du conducteur (WLK) de ligne à activer par la commande (2) d'accès aux lignes que lorsque la lecture ou l'écriture du signal (DA) de données est terminée et que lorsqu'un laps (tmin) de temps fixé, pendant lequel le conducteur (WLK) de lignes doit être au moins activé, s'est écoulé depuis l'activation.

9. Procédé suivant la revendication 8,
**caractérisé en ce que**
- on applique successivement plusieurs instructions (VB) de précharge pour précharger respectivement des conducteurs (WLK) de ligne,
- on effectue une mémorisation d'adresses (RADR) des conducteurs (WLK) de ligne préchargés respectifs,
- au moyen des adresses (RADR) mémorisées, on fixe un ordre suivant lequel les conducteurs (WLK) de ligne respectifs sont préchargés.

10. Procédé suivant la revendication 8 ou 9,
**caractérisé en ce que**
- on rassemble les cellules (MC) de mémoire en unités (BNK) de lignes, qui contiennent respectivement plusieurs conducteurs (WL) de lignes,
- on applique une instruction (VB) de précharge d'une unité (BNKi) de lignes à activer de cellules de mémoire,
- on active l'unité (BNKi) de lignes à activer pour la sélection de l'une des cellules (MC) de mémoire,
- on déclenche l'opération de précharge pour l'unité (BNKi) de lignes à activer, lorsque la lecture ou l'écriture du signal (Da) de données est terminée et lorsqu'un laps (tmin) de temps, pendant lequel l'unité (BNKi) de lignes doit être au moins activée, s'est écoulé depuis l'activation,
- on précharge l'unité (BNKi) de lignes à activer après le déclenchement de l'opération de précharge.
